# EUROPEAN PATENT SPECIFICATION

(11) **EP 2 122 682 B1**
(45) Date of publication and mention of the grant of the patent: **08.05.2019**
(21) Application number: 06817774.0
(22) Date of filing: 21.12.2006
(51) Int. Cl.: H01L 25/07, H01L 23/40

(54) **SEMICONDUCTOR MODULE**
HALBLEITERMODUL
MODULE SEMI-CONDUCTEUR

(43) Date of publication of application: 25.11.2009
(73) Proprietor: ABB Research Ltd, 8050 Zürich (CH)
(72) Inventor: KNAPP, Wolfgang, 5600 Lenzburg (CH); HÄDERLI, Christoph, 8047 Zürich (CH)
(74) Representative: Michalski Hüttermann & Partner Patentanwälte mbB
(86) International application number: PCT/CH2006/000724
(87) International publication number: WO 2008/074164

(56) References cited:
- EP-A- 1 318 545
- EP-A- 1 672 692
- US-A- 5 708 354

## Description

### Technical Field

The invention relates to the field of high power electronics and more particularly to a semiconductor module according to the preamble of the independent claims.

### Background Art

EP 1672692 shows a semiconductor module with a housing, in which two semiconductor chips are arranged. The chips are electrically and thermally contacted on a their main electrode sides with base plates. Each base plate is in thermal contact with a cooling plate. On one side the cooling plates of the two chips are formed as separate plates, whereas on the other side the cooling plates of the two chips are formed as a common cooling plate with a diminution in the area between the two chips. On each side the cooling plates prop against a half shell of a housing by inserting cooling fins between the cooling plate and each half shell. Compressible elements like rubber foam are arranged between the cooling fins and each half shell. The module is compressed by screws, which press both half shells with the chips, base plates, cooling plates and cooling fins in between. Due to the diminutions between the chips and the rubber foam differences in height of the staples comprising a chip and base plates on both sides of the chip can be balanced. Such a module can also be built up with more than two chips. In any case, all chips are compressed together within the same housing by the same compression means.

### Disclosure of Invention

It is an object of the invention to provide a semiconductor module with semiconductor chips, in which sub-units, each with at least one semiconductor chip, are individually compressed and the sub-units can be efficiently cooled and good electrical connection is provided between the sub-units.

This object is achieved by a semiconductor module according to claim 1.

The chips are preferably arranged in a plane, so that the space in both directions vertical to the main electrode sides of the chips can be used for cooling purposes. Thereby, an efficient two sided-cooling can be achieved. As the contact elements are connected to the chips on both main electrode sides of the chips, heat produced in the chips can be dissipated over a great surface and over short distances to the contact elements.

As each sub-unit has its own individual fixation means, differences in height between the staples of two sub-units can be easily compensated. Besides, the sub-units comprising one or more semiconductor chips can easily be premounted from one side. Therefore, the manufacturing of the module is easy.

There is no necessity for a housing for fixation purposes of the module. The module with the semiconductor chips sandwiched between the contact elements is a mechanically stable unit even without such a housing. The contact elements, which preferably are in contact with cooling fins, can be used with any fluid (gas like air or liquid like water) for an improved cooling.

By connecting two neighboured sub-units mechanically on one side by a first flexible element, which electrically and thermally contacts the two contact elements, a robust electrical connection can be achieved and the semiconductor module is suitable for high currents.

### Brief Description of Drawings

The subject matter of the invention will be explained in more detail in the following text with reference to the attached drawings, in which:
FIG 1 shows a cross sectional view of a semiconductor subassembly according to the invention;
FIG 2 shows a perspective view to a two-level-three -phase inverter according to the invention;
FIG 3 shows a top view to a two-level-three -phase inverter according to the invention;
FIG 4 shows a schematic diagram of a two-level-three -phase inverter according to the invention; and
FIG 5 shows a perspective view on another embodiment of a first submodule according to the invention.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

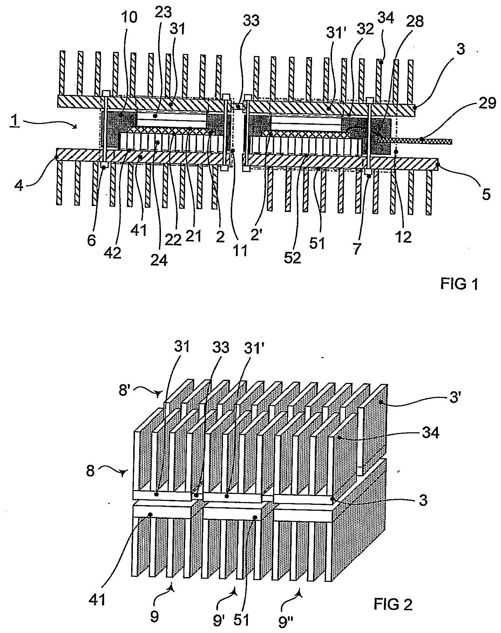

In FIG 1 a semiconductor module 1 according to the invention is shown. The semiconductor module 1 comprises a first sub-unit 11 with a first contact element 31 having cooling function, which first contact element 31 comprises a first contact side 32, and a second contact element 41 having cooling function, which second contact element 41 comprises a second contact side 42. The first sub-unit further comprises a first fixation means 6. At least one semiconductor chip 2 with a first main electrode side 21 and a second main electrode side 22 opposite the first main electrode side 21 is thermally connected on its first main electrode side 21 to the first contact side 32 and on its second main electrode side 22 to the second contact side 42. The first and second contact element 31, 41 and the semiconductor chip(s) 2 are firmly connected together by the first fixation means 6. At least one electrical connection is established between at least one semiconductor chip 2 and the first or second contact side 32, 42. In Fig. 1, the chip 2 is electrically connected to the first contact 32 side via an electrically conductive base plate 23, which is arranged between the chip 2 and the first contact element 31, and to the second contact 42 side via an electrically conductive base plate 24, which is arranged between the chip 2 and the second contact element 41. The first fixation means 6 can be a screw or a clamping device. Springs or other flexible or compressible elements can be used to improve the contact between the contact elements 31, 41, base plates 23, 24 and the chip 2.

It is also possible that at least one, but not all chips 2 are electrically connected on the first main side 21 to the first contact side 32 and/or at least one, but not all chips 2 is electrically connected on the second main electrode side 22 to the second contact side 42. Other combinations of electrical connections like all chips 2 of the first sub-unit 11 being electrically connected to the first and/or second contact side 32, 42 are also possible.

The semiconductor module 1 further comprises a second sub-unit 12 with a first contact element 31' having cooling function, which first contact element 31' comprises a first contact side 32, and with a third contact element 51 having cooling function, which third contact element 51 comprises a third contact side 52. At least one semiconductor chip 2', which has a first main electrode side 21 and a second main electrode side 22 opposite the first main electrode side 21, is thermally connected on its first main electrode side 21 to the first contact side 32 and on its second main electrode side 22 to the third contact side 52. Semiconductor chip 2' in FIG 1, typically a switch like an insulated gate bipolar transistor (IGBT), comprises a gate electrode, which is electrically connected by a gate connection 28 to an electrical connector 29, typically in the form of a lead frame. On the first main electrode side 21 of the chip 2' a base plate 23 is arranged, and on the second main electrode side 22 a base plate 24 is arranged. At least one electrical connection is established between at least one semiconductor chip 2' and the first or third contact side 32, 52. It is also possible for the second-unit 12 that at least one, but not all chips 2' are electrically connected on the first main side 21 to the first contact side 32 and/or at least one, but not all chips 2' are electrically connected on the second main electrode side 22 to the third contact side 52. Other combinations of electrical connections like all chips 2' of the second sub-unit 12 being electrically connected to the first and/or third contact side 32, 52 are also possible. The second sub-unit 12 comprises a second fixation means 7, by which the first and third contact element 31', 51 and the at least one semiconductor chip 2' are firmly connected together. The second fixation means 7 can be a screw or a clamping device. Springs or other flexible or compressible elements can be used to improve the contact between the contact elements 31', 51, base plates 23, 24 and the chip 2'.

At least one first flexible element 33 is arranged between the first contact element 31 of the first sub-unit 11 and the first contact element 31' of the second sub-unit 12. The at least one first flexible element 33 is electrically and thermally connected to the first contact element 31 of the first sub-unit 11 and to the first contact element 31' of the second sub-unit 12. Preferably, the first flexible element 33 is a cable strand. A cable strand has the advantage that good electrical connection is achieved via the cable strand and it has superior mechanical properties, i.e. it is stable, but has also good flexibility properties.

In another preferred embodiment, a first cooling element 3 comprises the first contact elements 31, 31' and typically also cooling fins 34 to improve the cooling properties of the device. The first cooling element 3 comprising the first contact elements 31, 31' and the flexible element 33 may be formed from one piece, e.g. by a diminution (e.g. by reducing the thickness or width) between the first contact elements 31, 31'. Any other first flexible element 33, which allows a vertical movement or shifting of two first contact elements 31, 31' against each other, which contact elements 31, 31' belong to one cooling element 3, but are part of two neighboured subunits 11 and 12, and which first flexible element 33 has appropriate electrical conductivity properties for a current to flow between the contact elements 31, 31' is also possible. The flexible element 33 may, e.g. comprises a bended or folded portion.

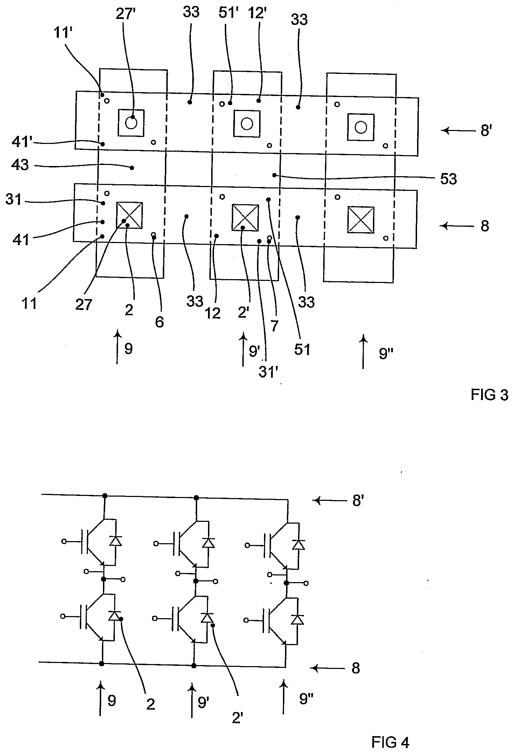

A second cooling element 4 comprises the second contact elements 41, 41' arranged in one line 9 and a third cooling element 5 comprises the third contact elements 51, 51' arranged in one line 9' (FIG 3). Typically, the cooling elements 4, 5 comprise cooling fins 34 to improve the cooling properties of the device.

Any of the sub-units 11, 11', 12, 12' may comprise only one semiconductor chip 2, 2', 2" like a diode, reverse conducting switch, bidirectional switch or more than one semiconductor chip 2, 2', 2", e.g. a co-package of IGBT with diode, in that case typically an antiparallel diode. A combination of different types of chips or more than one chip of one type or e.g. at least two chips as a staple one upon the other is also possible.

In another preferred embodiment of the inventive semiconductor module the first fixation means 6 is reversibly detachable from the first contact element 31, the at least one semiconductor chip 2 and /or the second contact element 41. The second fixation means 7 is a compression means, which is typically reversibly detachable from the first contact element 31', the at least one semiconductor chip 2' and / or the third contact element 51. Such reversible fixation means 6, 7 could be e.g. screws or screws in combination with springs, clamping means, bolts etc. Alternatively, the first and/or second fixation means 6, 7 is a bonding means, in particular a glue means or a solder means, which means are typically not reversibly attachable. It is also possible to use a combination of reversible and non-reversible fixation means, either by using them alternatively or by using them together (e.g. screw together with bonding).

If a bonding means is used or if in another way an appropriate electrical and thermal connection is achieved between the contact elements 31, 31', 41, 41', 51, 51' and the chips 2, 2', the contact elements 31, 31', 41, 41', 51 51' do not even need to be stiff, but could be partially or completely flexible. E.g. the first contact elements 31, 31' and first flexible elements 33 could be made of the same material, in particular of one piece.

In another preferred embodiment, the semiconductor chips 2, 2' are arranged in a plane. This plane can either be a flat plane or a curved plane, if it is advantageous for geometrical reasons.

FIG. 2 shows a perspective view on a two-level-three -phase inverter with chips 2, 2' being arranged in first lines 8, 8' and second lines 9, 9', 9". The first line 8 is typically a (DC+) electrical connection and the first line 8' a (DC-) electrical connection. The second lines 9, 9', 9" are typically the electrical connections for the three phases of the inverter.

FIG 3 shows a top view and FIG 4 shows a schematic diagram of the two-level-three-phase inverter shown in FIG 2. Typically, first sub-units 11, 11' and second sub-units 12,12' respectively are arranged in a matrix with the sub-units or chips 2, 2' being arranged in a first direction in first lines 8, 8' and in a second direction in second lines 9, 9', 9". The crosses 27 and circles 27' show the electrical conducting direction of the chips 2, 2', the crosses 27 being a direction from the first contact element 31 to the second contact element 41 and the circles being the opposite direction. In a preferred embodiment shown in FIG. 2 and 3, the first and second lines are arranged perpendicular to each other. A first sub-unit 11 is arranged together with a second sub-unit 12 in a first direction in a first line 8 and another first sub-unit 11' is arranged together with another second sub-unit 12' in the first direction in another first line 8'. The first sub-unit 11 and the first sub-unit 11' are arranged in a second direction in a second line 9 and the second sub-unit 12 and the second sub-unit 12' are arranged in the second direction in another second line 9'. An electrical connection is established between the second contact element 41 of the first sub-unit 11 and the second contact element 41' of the first sub-unit 11'. Alternatively or additionally an electrical connection is established between the third contact element 51 of the second sub-unit 12 and the third contact element 51' of the second sub-unit 12'.

FIG 4 shows a schematic diagram of the two-level-three-phase inverter shown in FIG 2. The semiconductor chips 2, 2', which are arranged in one second line 9, 9' or 9" are electrically connected in series.

Generally, chips within one line or within one sub-unit can be electrically connected in series, or parallel or anti-parallel or even in a combination thereof.

With sub-units 11, 11', 12, 12' being arranged in a matrix as described above, different kind of inverters or converters can be built like a matrix converter or a three-level neutral point clamped inverter.

In FIG 3 it is shown that a second flexible element 43 may be arranged between the second contact element 41 of the first sub-unit 11 and the second contact element 41' of the first sub-unit 11', the sub-units 11, 11' being arranged adjacent to each other in one second line 9. In this case, the second flexible element 43 is electrically and thermally connected to the second contact elements 41, 41'. A third flexible element 53 can also be arranged between the third contact element 51 of the second sub-unit 12 and the third contact element 51' of the second sub-unit 12', whereby the third flexible element 53 is electrically and thermally connected to the third contact elements 51, 51' of two neighboured sub-units 12, 12'.

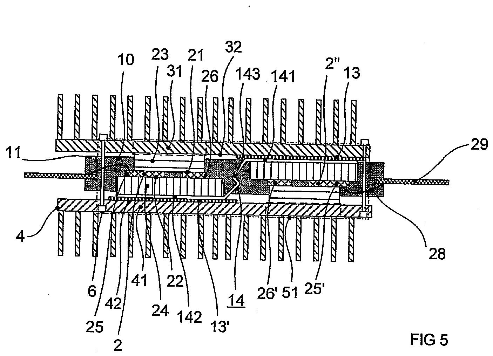

FIG 5 shows another embodiment of a first subunit 11 of an inventive semiconductor module 1. The first subunit 11 comprises semiconductor chips 2, 2", typically a number of gate controlled chips 25, 25", in particular insulated gate bipolar transistors (IGBTs) and a number of diodes 26, 26'. A gate controlled chip 25 and a diode 26 are electrically and thermally connected to the first contact element 31 on their first main side 21. On the second main side of the chips 25, 26, the chips 25, 26 are thermally connected to the second contact element 41. The chips 25, 26 are electrically connected to each other on their second main side 22 via (the base plate 24 and) an electrical connector 142 being arranged between the chips 25, 26 and the second contact element 41. An insulation layer 13' insulates the electrical connector 142 from the second contact element 41. Generally, at least one electrical connection is established between at least one semiconductor chip 2 on its first main electrode side 21 and the first contact side 32, and between the chip 2 on its second main electrode side 22 and an electrical connector 142.

Another chip 2" or a set of gate controlled chip 25' and diode 26' is arranged between the same first contact element 31 and the same second contact element 41, the chips 2" or 25', 26' being thermally connected to the contact elements 31, 41. The chip 2" or gate controlled chip 25' and diode 26' are electrically connected to the second contact element 41 on their second main side 22. On the first main side 21 of the chips 25', 26', the chips 25', 26' are electrically connected to each other via (base plate 23 and) an electrical connector 141 being arranged between the chips 25', 26' and the first contact element 31. An insulation layer 13 insulates the electrical connector 141 from the first contact element 31.

The electrical connector 141 is electrically connected to the electrical connector 142 via a third flexible, electrically conductive element 143, typically a spring, between the electrical connectors 141, 142. The electrical connectors 141, 142 and the flexible connection element 143 form a cross-over bar 14. In a preferred embodiment the electrical connectors 141, 142 and the third flexible element 143 are made from one piece. Of, course any type of semiconductor chips 2, 2' or more or less semiconductor chips can be arranged in the prescribed manner.

In another preferred embodiment, not shown in a figure, the semiconductor module 1 comprises at least one sub-unit 11, 11', 12, 12' with a number of chips 2, 2', 2", all of which are electrically insulated on one main side 21, 22. Either the chips are insulated from the first contact element 31 by an insulation layer 13, 13' being arranged between the first main side 21 and the first contact element 31, but which chips are electrically connected to each other by an electrical connector layer, arranged between the chips 2, 2', 2" on their first main electrode side 21 and the insulation layer 13, 13'. Alternatively the chips may be insulated from the second contact element 41 by an insulation layer 13, 13' being arranged between the second main side 22 and the second contact element 41, but which chips are electrically connected to each other by an electrical connector layer, arranged between the chips 2, 2', 2" on their second main electrode side 22 and the insulation layer 13, 13'.

The semiconductor module according to the invention can be applied in many electrical devices like a converter, inverter, motor drive, rectifier, power supply or a power factor controller.

### Reference List

- 1: Semiconductor module
- 11, 11': first sub-unit
- 12, 12': second sub-unit
- 13, 13': insulation layer
- 14: cross-over bar
- 141: electrical connector
- 142: electrical connector
- 143: third flexible element
- 2, 2', 2": semiconductor chip
- 21: first main electrode side
- 22: second main electrode side
- 23, 24: base plate
- 25, 25': gate controlled chips
- 26, 26': diode
- 27, 27': electrical conductivity direction
- 28: gate electrode
- 29: gate connection
- 3, 3': first cooling element
- 31, 31': first contact element
- 32: first contact side
- 33: first flexible element
- 34: cooling fins
- 4: second cooling element
- 41, 41': second contact element
- 42: second contact side
- 43: second flexible element
- 5: third cooling element
- 51, 51': third contact element
- 52: third contact side
- 53: third flexible element
- 6: first fixation means
- 7: second fixation means
- 8, 8': first line
- 9, 9': second line
- 10: insulator

## Claims

1. Semiconductor module (1) comprising
a first sub-unit (11, 11') with a first contact element (31) having cooling function, which first contact element (31) comprises a first contact side (32), with a second contact element (41, 41') having cooling function, which second contact element (41, 41') comprises a second contact side (42), with a first fixation means (6) and with at least one semiconductor chip (2, 2"), which has a first main electrode side (21) and a second main electrode side (22) opposite the first main electrode side (21), the at least one semiconductor chip (2, 2") being thermally connected on its first main electrode side (21) to the first contact side (32) and on its second main electrode side (22) to the second contact side (42), and at least one electrical connection is established between at least one semiconductor chip (2, 2") and the first or second contact side (32, 42), the first and second contact element (31, 41, 41') and the at least one semiconductor chip (2, 2") being firmly connected together by the first fixation means (6),
the semiconductor module (1) comprising a second sub-unit (12, 12'), with a first contact element (31') having cooling function, which first contact element (31') comprises a first contact side (32), with a third contact element (51, 51') having cooling function, which third contact element (51, 51') comprises a third contact side (52), and with at least one semiconductor chip (2'), which has a first main electrode side (21) and a second main electrode side (22) opposite the first main electrode side (21), the at least one semiconductor chip (2') being thermally connected on its first main electrode side (21) to the first contact side (32) and on its second main electrode side (22) to the third contact side (52), and at least one electrical connection is established between at least one semiconductor chip (2') and the first or third contact side (32, 52),
the semiconductor module (1) comprising at least one first flexible element (33), which is arranged between the first contact element (31) of the first sub-unit (11, 11') and the first contact element (31') of the second sub-unit (12, 12') and which at least one first flexible element (33) is electrically and thermally connected to the first contact element (31) of the first sub-unit (11, 11') and to the first contact element (31') of the second sub-unit (12, 12'), wherein the second sub-unit (12, 12') comprises a second fixation means (7) and the first and third contact element (31', 51, 51') and the at least one semiconductor chip (2') are firmly connected together by the second fixation means (7), **characterized in that** the first sub-unit (11, 11') is individually compressed by the first fixation means (6) and **in that** the second sub-unit (12, 12') is individually compressed by the second fixation means (7).

2. Semiconductor module (1) according to claim 1, **characterized in that** at least one electrical connection is established in the first sub-unit (11, 11') between at least one semiconductor chip (2, 2") and the first contact side (32) and at least one electrical connection is established between at least one semiconductor chip (2, 2") and the second contact side (42).

3. Semiconductor module (1) according to claim 1 or 2, **characterized in that**
at least one electrical connection is established in the second sub-unit (12, 12') between at least one semiconductor chip (2') and the first contact side (32) and at least one electrical connection is established between at least one semiconductor chip (2') and the third contact side (52).

4. Semiconductor module (1) according to any of the claims 1 to 3, **characterized in that** the at least one semiconductor chip (2, 2") and the at least one semiconductor chip (2') are arranged in a plane.

5. Semiconductor module (1) according to claim 4, **characterized in that** the plane is flat.

6. Semiconductor module (1) according to claim 4, **characterized in that** the plane is curved.

7. Semiconductor module (1) according to any of the claims 1 to 6, **characterized in that** the first contact element (31) of the first sub-unit (11, 11') and the first contact element (31') of the second sub-unit (12, 12') and the at least one first flexible element (33) is formed from one piece.

8. Semiconductor module (1) according to any of the claims 1 to 3, **characterized in that** the at least one first flexible element (33) is a cable strand.

9. Semiconductor module (1) according to claim 1, **characterized in that** the first sub-unit (11, 11') comprises at least two semiconductor chips (2, 2"), **in that** at least one electrical connection is established between at least one semiconductor chip (2) on its first main electrode side (21) and the first contact side (32), and between said at least one semiconductor chip (2) on its second main electrode side (22) and an electrical connector (142), an insulation layer (13') being arranged between and electrically insulating the electrical connector (142) and the second contact element (41),
at least one electrical connection is established between at least one other semiconductor chip (2") on its second main side (22) and the second contact side (42) and between said at least one semiconductor chip (2") on its first main electrode side (21) and an electrical connector (141), an insulation layer (13) being arranged between and electrically insulating the electrical connector (141) and the first contact element (31, 31'), and **in that** the electrical connectors (141, 142) are electrically connected via a third flexible element (143).

10. Semiconductor module (1) according to claim 1, **characterized in that** a first sub-unit (11) is arranged together with a second sub-unit (12) in a first direction in a first line (8), another first sub-unit (11') is arranged together with another second sub-unit (12') in the first direction in another first line (8'),
the first sub-unit (11) and the first sub-unit (11') being arranged in a second direction in a second line (9) and the second sub-unit (12) and the second sub-unit (12') being arranged in the second direction in another second line (9'), **in that** an electrical connection is established between the second contact element (41) of the first sub-unit (11) and the second contact element (41') of the first sub-unit (11'), and/or
an electrical connection is established between the third contact element (51) of the second sub-unit (12) and the third contact element (51') of the second sub-unit (12').

11. Semiconductor module (1) according to claim 10, **characterized in that** a second flexible element (43) is arranged between the second contact element (41) of the first sub-unit (11) and the second contact element (41') of the first sub-unit (11'), which second flexible element (43) is electrically and thermally connected to said second contact elements (41, 41') and/or a third flexible element (53) is arranged between the third contact element (51) of the second sub-unit (12) and the third contact element (51') of the second sub-unit (12'), which third flexible element (53) is electrically and thermally connected to said third contact elements (51, 51').

12. Semiconductor module (1) according to any of the claims 10 or 11, **characterized in that** the first contact elements (31, 31') arranged in one first line (8, 8') form a stiff first cooling element and/or the second contact elements (41, 41') arranged in one second line (9) form a stiff second cooling element and/or the third contact elements (51, 51') arranged in one second line (9') form a stiff third cooling element.

13. Semiconductor module (1) according to any of the claims 1 to 12, **characterized in that** the first fixation means (6) is reversibly detachable from the first contact element (31, 31'), the at least one semiconductor chip (2) and /or the second contact element (41) and /or **in that** the second fixation means (7) is reversibly detachable from the first contact element (31, 31'), the at least one semiconductor chip (2') and / or the third contact element (51).

14. Semiconductor module (1) according to any of the claims 1 to 12, **characterized in that** the first and / or second fixation means (6, 7) is a compression means or a bonding means, in particular a glue means or a solder means.

15. Semiconductor module (1) according to any of the preceding claims applied in a converter, inverter, motor drive, rectifier, power supply or power factor controller.

## Patentansprüche

1. Halbleitermodul (1), umfassend:
eine erste Untereinheit (11, 11') mit einem ersten Kontaktelement (31) mit Kühlfunktion, wobei das erste Kontaktelement (31) eine erste Kontaktseite (32) umfasst, mit einem zweiten Kontaktelement (41, 41') mit Kühlfunktion, wobei das zweite Kontaktelement (41, 41') eine zweite Kontaktseite (42) umfasst, mit einem ersten Fixiermittel (6) und mit mindestens einem Halbleiterchip (2, 2"), der eine erste Hauptelektrodenseite (21) und eine zur ersten Hauptelektrodenseite (21) entgegengesetzte zweite Hauptelektrodenseite (22) aufweist, wobei der mindestens eine Halbleiterchip (2, 2") auf seiner ersten Hauptelektrodenseite (21) mit der ersten Kontaktseite (32) und auf seiner zweiten Hauptelektrodenseite (22) mit der zweiten Kontaktseite (42) thermisch verbunden ist und mindestens eine elektrische Verbindung zwischen mindestens einem Halbleiterchip (2, 2") und der ersten oder der zweiten Kontaktseite (32, 42) eingerichtet ist, wobei das erste und das zweite Kontaktelement (31, 41, 41') und der mindestens eine Halbleiterchip (2, 2") durch das erste Fixiermittel (6) fest miteinander verbunden sind,
wobei das Halbleitermodul (1) eine zweite Untereinheit (12, 12') umfasst mit einem ersten Kontaktelement (31') mit Kühlfunktion, wobei das erste Kontaktelement (31') eine erste Kontaktseite (32) umfasst, mit einem dritten Kontaktelement (51, 51') mit Kühlfunktion, wobei das dritte Kontaktelement (51, 51') eine dritte Kontaktseite (52) umfasst, und mit mindestens einem Halbleiterchip (2'), der eine erste Hauptelektrodenseite (21) und eine zur ersten Hauptelektrodenseite (21) entgegengesetzte zweite Hauptelektrodenseite (22) aufweist, wobei der mindestens eine Halbleiterchip (2') auf seiner ersten Hauptelektrodenseite (21) mit der ersten Kontaktseite (32) und auf seiner zweiten Hauptelektrodenseite (22) mit der dritten Kontaktseite (52) thermisch verbunden ist und mindestens eine elektrische Verbindung zwischen mindestens einem Halbleiterchip (2') und der ersten oder der dritten Kontaktseite (32, 52) eingerichtet ist,
wobei das Halbleitermodul (1) mindestens ein erstes flexibles Element (33) umfasst, das zwischen dem ersten Kontaktelement (31) der ersten Untereinheit (11, 11') und dem ersten Kontaktelement (31') der zweiten Untereinheit (12, 12') angeordnet ist, und wobei das mindestens eine erste flexible Element (33) elektrisch und thermisch mit dem ersten Kontaktelement (31) der ersten Untereinheit (11,11') und mit dem ersten Kontaktelement (31') der zweiten Untereinheit (12,12') verbunden ist, wobei die zweite Untereinheit (12, 12') ein zweites Fixiermittel (7) umfasst und das erste und das dritte Kontaktelement (31', 51, 51') und der mindestens eine Halbleiterchip (2') durch das zweite Fixiermittel (7) fest miteinander verbunden sind,
**dadurch gekennzeichnet, dass** die erste Untereinheit (11, 11') für sich vom ersten Fixiermittel (6) komprimiert wird und dass die zweite Untereinheit (12, 12') für sich vom zweiten Fixiermittel (7) komprimiert wird.

2. Halbleitermodul (1) nach Anspruch 1, **dadurch gekennzeichnet, dass** in der ersten Untereinheit (11, 11') mindestens eine elektrische Verbindung zwischen mindestens einem Halbleiterchip (2, 2") und der ersten Kontaktseite (32) eingerichtet ist und mindestens eine elektrische Verbindung zwischen mindestens einem Halbleiterchip (2, 2") und der zweiten Kontaktseite (42) eingerichtet ist.

3. Halbleitermodul (1) nach Anspruch 1 oder 2, **dadurch gekennzeichnet, dass**
mindestens eine elektrische Verbindung in der zweiten Untereinheit (12, 12') zwischen mindestens einem Halbleiterchip (2') und der ersten Kontaktseite (32) eingerichtet ist und mindestens eine elektrische Verbindung zwischen mindestens einem Halbleiterchip (2') und der dritten Kontaktseite (52) eingerichtet ist.

4. Halbleitermodul (1) nach einem der Ansprüche 1 bis 3, **dadurch gekennzeichnet, dass** der mindestens eine Halbleiterchip (2, 2") und der mindestens eine Halbleiterchip (2') in einer Ebene angeordnet sind.

5. Halbleitermodul (1) nach Anspruch 4, **dadurch gekennzeichnet, dass** die Ebene flach ist.

6. Halbleitermodul (1) nach Anspruch 4, **dadurch gekennzeichnet, dass** die Ebene gekrümmt ist.

7. Halbleitermodul (1) nach einem der Ansprüche 1 bis 6, **dadurch gekennzeichnet, dass** das erste Kontaktelement (31) der ersten Untereinheit (11, 11') und das erste Kontaktelement (31') der zweiten Untereinheit (12, 12') und das mindestens eine flexible Element (33) einstückig ausgebildet sind.

8. Halbleitermodul (1) nach einem der Ansprüche 1 bis 3, **dadurch gekennzeichnet, dass** das mindestens eine flexible Element (33) ein Kabelstrang ist.

9. Halbleitermodul (1) nach Anspruch 1, **dadurch gekennzeichnet, dass** die erste Untereinheit (11, 11') mindestens zwei Halbleiterchips (2,2") umfasst, dass mindestens eine elektrische Verbindung zwischen dem mindestens einen Halbleiterchip (2) auf dessen erster Hauptelektrodenseite (21) und der ersten Kontaktseite (32) und zwischen dem mindestens einen Halbleiterchip (2) auf dessen zweiter Hauptelektrodenseite (22) und einem elektrischen Verbinder (142) eingerichtet ist, wobei der elektrische Verbinder (142) und das zweite Kontaktelement (41) von einer zwischen ihnen angeordneten Isolierschicht (13') elektrisch voneinander isoliert werden,
mindestens eine elektrische Verbindung zwischen mindestens einem anderen Halbleiterchip (2") auf dessen zweiter Hauptseite (22) und der zweiten Kontaktseite (42) und zwischen dem mindestens einen Halbleiterchip (2") auf dessen erster Hauptelektrodenseite (21) und einem elektrischen Verbinder (141) eingerichtet ist, wobei der elektrische Verbinder (141) und das erste Kontaktelement (31,31') von einer zwischen ihnen angeordneten Isolierschicht (13) elektrisch voneinander isoliert werden, und dass die elektrischen Verbinder (141, 142) über ein drittes flexibles Element (143) elektrisch verbunden sind.

10. Halbleitermodul (1) nach Anspruch 1, **dadurch gekennzeichnet, dass** eine erste Untereinheit (11) zusammen mit einer zweiten Untereinheit (12) in einer ersten Richtung auf einer ersten Linie (8) angeordnet ist, eine andere erste Untereinheit (11') zusammen mit einer anderen zweiten Untereinheit (12') in der ersten Richtung auf einer anderen ersten Linie (8') angeordnet ist,
die erste Untereinheit (11) und die erste Untereinheit (11') in einer zweiten Richtung auf einer zweiten Linie (9) angeordnet sind und die zweite Untereinheit (12) und die zweite Untereinheit (12') in der zweiten Richtung auf einer anderen zweiten Linie (9') angeordnet sind, dass eine elektrische Verbindung zwischen dem zweiten Kontaktelement (41) der ersten Untereinheit (11) und dem zweiten Kontaktelement (41') der ersten Untereinheit (11') eingerichtet ist, und/oder
eine elektrische Verbindung zwischen dem dritten Kontaktelement (51) der zweiten Untereinheit (12) und dem dritten Kontaktelement (51') der zweiten Untereinheit (12') eingerichtet ist.

11. Halbleitermodul (1) nach Anspruch 10, **dadurch gekennzeichnet, dass** ein zweites flexibles Element (43) zwischen dem zweiten Kontaktelement (41) der ersten Untereinheit (11) und dem zweiten Kontaktelement (41') der ersten Untereinheit (11') angeordnet ist, wobei das zweite flexible Element (43) elektrisch und thermisch mit den zweiten Kontaktelementen (41, 41 ') verbunden ist und/oder ein drittes flexibles Element (53) zwischen dem dritten Kontaktelement (51) der zweiten Untereinheit (12) und dem dritten Kontaktelement (51') der zweiten Untereinheit (12') angeordnet ist, wobei das dritte flexible Element (53) elektrisch und thermisch mit den dritten Kontaktelementen (51, 51') verbunden ist.

12. Halbleitermodul (1) nach einem der Ansprüche 10 oder 11, **dadurch gekennzeichnet, dass** die ersten Kontaktelemente (31, 31'), die auf einer ersten Linie (8, 8') angeordnet sind, ein steifes erstes Kühlelement bilden und/oder die zweiten Kühlelemente (41,41'), die auf einer zweiten Linie (9) angeordnet sind, ein steifes zweites Kühlelement bilden und/oder die dritten Kontaktelemente (51, 51', die auf einer zweiten Linie (9') angeordnet sind, ein steifes drittes Kühlelement bilden.

13. Halbleitermodul (1) nach einem der Ansprüche 1 bis 12, **dadurch gekennzeichnet, dass** das erste Fixiermittel (6) vom ersten Kontaktelement (31, 31'), von dem mindestens einen Halbleiterchip (2) und/oder vom zweiten Kontaktelement (41) reversibel lösbar ist und/oder dass das zweite Fixiermittel (7) vom ersten Kontaktelement (31, 31'), von dem mindestens einen Halbleiterchip (2') und/oder vom dritten Kontaktelement (51) reversibel lösbar ist.

14. Halbleitermodul (1) nach einem der Ansprüche 1 bis 12, **dadurch gekennzeichnet, dass** das erste und/oder das zweite Fixiermittel (6, 7) ein Kompressionsmittel oder ein Fügemittel ist, insbesondere eine Leimmittel oder eine Lotmittel.

15. Halbleitermodul (1) nach einem der vorangehenden Ansprüche, die in einem Wandler, Wechselrichter, Motorantrieb, Gleichrichter, Leistungszufuhr- oder Leistungsfaktorsteuereinrichtung angewendet wird.

## Revendications

1. Module semi-conducteur (1), comprenant
une première sous-unité (11, 11') avec un premier élément de contact (31) ayant une fonction de refroidissement, lequel premier élément de contact (31) comprend une première face de contact (32), avec un deuxième élément de contact (41, 41') ayant une fonction de refroidissement, lequel deuxième élément de contact (41, 41') comprend une deuxième face de contact (42), avec un premier moyen de fixation (6) et avec au moins une puce semi-conductrice (2, 2"), laquelle a un premier côté d'électrode principale (21) et un second côté d'électrode principale (22) opposé au premier côté d'électrode principale (21), l'au moins une puce semi-conductrice (2, 2") étant connectée de manière thermique sur son premier côté d'électrode principale (21) à la première face de contact (32) et sur son second côté d'électrode principale (22) à la deuxième face de contact (42), et au moins une connexion électrique est établie entre au moins une puce semi-conductrice (2, 2") et la première ou la deuxième face de contact (32, 42), le premier et le deuxième élément de contact (31, 41, 41') et l'au moins une puce semi-conductrice (2, 2") étant solidement connectés les uns avec les autres par le premier moyen de fixation (6),
le module semi-conducteur (1) comprenant une seconde sous-unité (12, 12'), avec un premier élément de contact (31') ayant une fonction de refroidissement, lequel premier élément de contact (31') comprend une première face de contact (32), avec un troisième élément de contact (51, 51') ayant une fonction de refroidissement, lequel troisième élément de contact (51, 51') comprend une troisième face de contact (52), et avec au moins une puce semi-conductrice (2'), laquelle a un premier côté d'électrode principale (21) et un second côté d'électrode principale (22) opposé au premier côté d'électrode principale (21), l'au moins une puce semi-conductrice (2') étant connectée de manière thermique au niveau de son premier côté d'électrode principale (21) à la première face de contact (32) et au niveau de son second côté d'électrode principale (22) à la troisième face de contact (52), et au moins une connexion électrique est établie entre au moins une puce semi-conductrice (2') et la première ou la troisième face de contact (32, 52),
le module semi-conducteur (1) comprenant au moins un premier élément souple (33), lequel est disposé entre le premier élément de contact (31) de la première sous-unité (11, 11') et le premier élément de contact (31') de la seconde sous-unité (12, 12') et lequel au moins un premier élément souple (33) est connecté de manière thermique et électrique au premier élément de contact (31) de la première sous-unité (11, 11') et au premier élément de contact (31') de la seconde sous-unité (12, 12'), où la seconde sous-unité (12, 12') comprend un second moyen de fixation (7) et le premier et le troisième élément de contact (31', 51, 51') et l'au moins une puce semi-conductrice (2') sont solidement connectés les uns avec les autres par le second moyen de fixation (7),
**caractérisé**
**en ce que** la première sous-unité (11, 11') est comprimée individuellement par le premier moyen de fixation (6) et **en ce que** la seconde sous-unité (12, 12') est comprimée individuellement par le second moyen de fixation (7).

2. Module semi-conducteur (1) selon la revendication 1, **caractérisé en ce qu'**au moins une connexion électrique est établie dans la première sous-unité (11, 11') entre au moins une puce semi-conductrice (2, 2") et la première face de contact (32) et au moins une connexion électrique est établie entre au moins une puce semi-conductrice (2, 2") et la deuxième face de contact (42).

3. Module semi-conducteur (1) selon la revendication 1 ou la revendication 2,
**caractérisé en ce**
**qu'**au moins une connexion électrique est établie dans la seconde sous-unité (12, 12') entre au moins une puce semi-conductrice (2') et la premier face de contact (32) et au moins une connexion électrique est établie entre au moins une puce semi-conductrice (2') et la troisième face de contact (52).

4. Module semi-conducteur (1) selon l'une quelconque des revendications 1 à 3,
**caractérisé en ce que** l'au moins une puce semi-conductrice (2, 2") et l'au moins une puce semi-conductrice (2') sont disposées dans un plan.

5. Module semi-conducteur (1) selon la revendication 4, **caractérisé en ce que** le plan est plat.

6. Module semi-conducteur (1) selon la revendication 4, **caractérisé en ce que** le plan est incurvé.

7. Module semi-conducteur (1) selon l'une quelconque des revendications 1 à 6,
**caractérisé en ce que** le premier élément de contact (31) de la première sous-unité (11, 11') et le premier élément de contact (31') de la seconde sous-unité (12, 12') et l'au moins un premier élément souple (33) sont formés à partir d'une seule pièce.

8. Module semi-conducteur (1) selon l'une quelconque des revendications 1 à 3, **caractérisé en ce que** l'au moins un premier élément souple (33) est un brin de câble.

9. Module semi-conducteur (1) selon la revendication 1, **caractérisé en ce que** la première sous-unité (11, 11') comprend au moins deux puces semi-conductrices (2, 2"), **en ce qu'**au moins une connexion électrique est établie entre au moins une puce semi-conductrice (2) sur son premier côté d'électrode principale (21) et la première face de contact (32), et entre ladite au moins une puce semi-conductrice (2) sur son second côté d'électrode principale (22) et un connecteur électrique (142), une couche isolante (13') étant disposée entre et isolant électriquement le connecteur électrique (142) et le deuxième élément de contact (41),
au moins une connexion électrique est établie entre au moins une autre puce semi-conductrice (2") sur son second côté d'électrode principal (22) et la deuxième face de contact (42) et entre ladite au moins une puce semi-conductrice (2") sur son premier côté d'électrode principale (21) et un connecteur électrique (141), une couche isolante (13) étant disposée entre et isolant électriquement le connecteur électrique (141) et le premier élément de contact (31, 31'), et **en ce que** les connecteurs électriques (141, 142) sont connectés électriquement par l'intermédiaire d'un troisième élément souple (143).

10. Module semi-conducteur (1) selon la revendication 1, **caractérisé en ce qu'**une première sous-unité (11) est disposée conjointement avec une seconde sous-unité (12) dans une première direction en une première ligne (8), une autre première sous-unité (11') est disposée conjointement avec une autre seconde sous-unité (12') dans la première direction en une autre première ligne (8'),
la première sous-unité (11) et la première sous-unité (11') étant disposées dans une seconde direction en une seconde ligne (9) et la seconde sous-unité (12) et la seconde sous-unité (12') étant disposées dans le seconde direction en une autre seconde ligne (9'), **en ce qu'**une connexion électrique est établie entre le deuxième élément de contact (41) de la première sous-unité (11) et le deuxième élément de contact (41') de la première sous-unité (11'), et/ou
une connexion électrique est établie entre le troisième élément de contact (51) de la seconde sous-unité (12) et le troisième élément de contact (51') de la seconde sous-unité (12').

11. Module semi-conducteur (1) selon la revendication 10, **caractérisé en ce qu'**un deuxième élément souple (43) est disposé entre le deuxième élément de contact (41) de la première sous-unité (11) et le deuxième élément de contact (41') de la première sous-unité (11'), lequel deuxième élément souple (43) est connecté de manière thermique et électrique auxdits deuxièmes éléments de contact (41, 41'), et/ou un troisième élément souple (53) est disposé entre le troisième élément de contact (51) de la seconde sous-unité (12) et le troisième élément de contact (51') de la seconde sous-unité (12'), lequel troisième élément souple (53) est connecté de manière thermique et électrique auxdits troisièmes éléments de contact (51, 51').

12. Module semi-conducteur (1) selon l'une quelconque des revendications 10 ou 11,
**caractérisé en ce que** les premiers éléments de contact (31, 31') disposés en une première ligne (8, 8') forment un premier élément de refroidissement rigide et/ou les deuxièmes éléments de contact (41, 41') disposés en une seconde ligne (9) forment un deuxième élément de refroidissement rigide et/ou les troisièmes éléments de contact (51, 51') disposés en une seconde ligne (9') forment un troisième élément de refroidissement rigide.

13. Module semi-conducteur (1) selon l'une quelconque des revendications 1 à 12,
**caractérisé en ce que** le premier moyen de fixation (6) est détachable de manière réversible du premier élément de contact (31, 31'), de l'au moins une puce semi-conductrice (2) et/ou du deuxième élément de contact (41), et/ou **en ce que** le second moyen de fixation (7) est détachable de manière réversible du premier élément de contact (31, 31'), de l'au moins une puce semi-conductrice (2') et/ou du troisième élément de contact (51).

14. Module semi-conducteur (1) selon l'une quelconque des revendications 1 à 12,
**caractérisé en ce que** le premier et/ou le second moyen de fixation (6, 7) est un moyen de compression ou un moyen de liaison, en particulier un moyen de collage ou un moyen de soudage.

15. Module semi-conducteur (1) selon l'une quelconque des revendications précédentes, utilisé dans un convertisseur, un onduleur, un entraînement par moteur, un redresseur, une alimentation électrique ou une commande de facteur de puissance.
